# EUROPEAN PATENT SPECIFICATION

(11) **EP 0 836 628 B1**
(45) Date of publication and mention of the grant of the patent: **15.10.2003**
(21) Application number: 96920548.3
(22) Date of filing: 28.05.1996
(51) Int. Cl.: C08G 61/02

(54) **PROCESS FOR PREPARING POLYHYDROXYSTYRENE WITH A NOVOLAK TYPE STRUCTURE**
VERFAHREN ZUR HERSTELLUNG VON POLYHYDROXYSTYRENEN MIT NOVOLAKSTRUKTUR
PROCEDE DE PREPARATION DE POLYHYDROXYSTYRENE A STRUCTURE DE TYPE NOVOLAQUE

(30) Priority: 16.06.1995 US 491424; 16.06.1995 US 491464
(43) Date of publication of application: 22.04.1998
(73) Proprietor: TRIQUEST L.P., Dallas, Texas (US)
(72) Inventor: SOUNIK, James, R., Corpus Christi, TX 78414 (US)
(74) Representative: James, Anthony Christopher W.P.
(86) International application number: US9607901
(87) International publication number: WO97000278

(56) References cited:
- US-A- 3 979 462
- POLYMERS FOR ADVANCED TECHNOLOGIES, vol. 5, no. 1, 1 January 1994, pages 2-11, XP000429974 TORU KAJITA ET AL: "RESIST PERFORMANCES AND STRUCTURE OF PHENOLIC RESINS USING MULTI-SUBSTITUTED PHENOLS"

## Description

### BACKGROUND OF THE INVENTION

### Field of the Invention

The present invention relates to a process for the production of polyhydroxystyrene (PHS) directly from a substituted phenyl carbinol ("carbinol") such as 4-hydroxymethyl-carbinol (HPMC) and which PHS has a novolak type structure which has utility in the electronic chemicals market such as photoresist compositions.

### Description of the Prior Art

In the past, one of the ways of preparing polyhydroxystyrene (PHS) was the use of 4-hydroxystyrene (HSM) as the starting material; note European Patent Application No. 0-108-624. 4-Hydroxystyrene is a well-known compound in the art.

Although there are several known ways to prepare 4-hydroxystyrene, these known methods are not commercially feasible in the further utilization of the 4-hydroxystyrene. The 4-hydroxystyrene itself is difficult to isolate since it (1) readily decomposes, and (2) is toxic via skin absorption and, as a result, those skilled in the art have made numerous attempts at finding a method of synthesizing PHS in a manner which avoids using the 4-hydroxystyrene as the starting material.

U.S. 5,087,772 (issued February 11, 1992) discloses the preparation of HSM by reacting acetoxystyrene (ASM) with a suitable alcohol in the presence of a catalytic amount of a suitable base.

U.S. 5,340,687 discloses the alkylation of a linear polyhydroxystyrene.

EP-A 0-128-984 filed August 30, 1983 discloses a process for the production of para-vinyl phenol (HSM) by dehydrogenation of paraethyl phenol.

EP-A 0-108-624 filed November 4, 1983, discloses a process for the production of p-vinyl phenol polymer (polyhydroxystyrene polymer - PHS) by polymerizing p-vinyl (HSM) in the presence of water and iron.

U.S. 4,032,513 (issued June 28, 1977) discloses a process of producing PHS by cationically polymerizing HSM in the presence of a nitrile such as CH₃CN using a cationic polymerization initiator in a homogeneous reaction system.

Other prior art references which relate to the present invention include U.S. 2,276,138; U.S. 3,547,858, U.S. 4,544,704; U.S. 4,678,843; U.S. 4,689,371; U.S. 4,822,862; U.S. 4,857;601; U.S. 4,868,256; U.S. 4,877,843; U.S. 4,898,916; U.S. 4,912,173; U.S. 4,962,147; and U.S. 4,965,400.

### SUMMARY OF THE INVENTION

A process for preparing a polyhydroxystyrene having a novolak type structure which comprises the step of polymerizing a mixture of a more than equivalent molar amount of carboxylic acid and at least one substituted phenyl carbinol whose formula is: 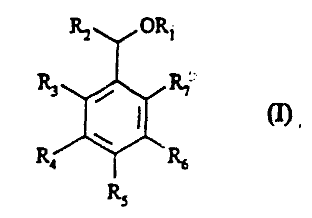 wherein (a) R₁ is selected from the group consisting of H, alkyl C₁-C₂₀, substituted and unsubstituted phenyl, and C(O)R₈ (where R₈ is alkyl C₁-C₂₀); (b) R₂ is selected from the group consisting of alkyl C₁-C₂₀; and (c) R₃-R₇ are each independently selected from the group consisting of H, alkyl C₁-C₂₀, OR₉ (where R₉ is H, alkyl C₁-C₂₀, esters thereof, or substituted and unsubstituted phenyl), halogen, BZT, nitro, or amino, with the proviso that at least one of R₃-R₇ is OR₉ in the presence of a suitable catalyst for a sufficient period of time and under suitable conditions of temperature and pressure to form said novolak type polymer, which is a unique and new PHS polymeric material having a molecular weight of from about 1,000 to about 500,000, preferably from 1,000 to 100,000 and more preferably from 1,000 to 30,000.

Referred features of the present invention are defined in the appended claims.

Substituted phenyl as used herein means phenyl substituted by at least one substituent selected from the group consisting of halogen (chlorine, bromine, fluorine, or iodine), amino, nitro, hydroxy, alkyl, alkoxy which means straight or branched chain alkoxy having 1 to 10 carbon atoms, and includes, for example, methoxy, ethoxy, propoxy, isopropoxy, butoxy, isobutoxy, secondary butoxy, tertiary butoxy, pentyloxy, isopentyloxy, hexyloxy, hepyloxy, octyloxy, nonyloxy, and decyloxy, haloalkyl which means straight or branched chain alkyl having 1 to 8 carbon atoms which is substituted by at least one halogen, and includes, for example, chloromethyl, bromomethyl, fluoromethyl, iodomethyl, 2-chloroethyl, 2-bromoethyl, 2-fluoroethyl, 3-chloropropyl, 3-bromopropyl, 3-fluoropropyl, 4-chlorobutyl, 4-fluorobutyl dichloromethyl, dibromomethyl, difluoromethyl, diiodomethyl, 2,2-dichloroethyl, 2,2-dibromoethyl, 2,2-difluoroethyl, 3,3-dichloropropyl, 3,3-difluoropropyl, 4,4-dichlorobutyl, 4,4-difluorobutyl, trichloromethyl, 4,4-difluorobutyl, trichloromethyl, trifluoromethyl, 2,2,2-trifluoroethyl, 2,3,3-trifluoropropyl, 1,1,2,2-tetrafluoroethyl, and 2,2,3,3-tetrafluoropropyl.

In the above definitions and throughout the present specification, alkyl means straight or branched chain alkyl having 1 to 20 carbon atoms, and includes, for example, methyl, ethyl, propyl, isopropyl, butyl, isobutyl, secondary butyl, tertiary butyl, pentyl, isopentyl, neopentyl, hexyl, heptyl, octyl, 2-ethylhexyl, 1,1,3,3-tetramethylbutyl, nonyl, decyl, dodecyol, tetradecyl, nexadecyl, octadecyl, and eicosyl.

In conjunction with formula I and the definitions of R₃-R₇, (a) "BZT" means benzotriazole and has the structural formula: 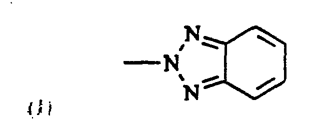 and (b) halogen means Cl, Br, I, and F.

As used herein, the term PHS (polyhydroxystyrene) refers to a polymer, copolymer, or block polymer having at least some hydroxy groups in the structure. It is to be understood that there may additionally be present and/or used other monomers which may, but need not, contain a hydroxy group. These other monomers include, without limitation, (a) compounds (including substituted phenols) of the formula 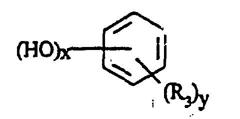 where x = 0-6 and y=0-6 and R₃ is the same as defined herein; and (b) substituted compounds (including diarylalkyls or triarylalkyls) of the formula 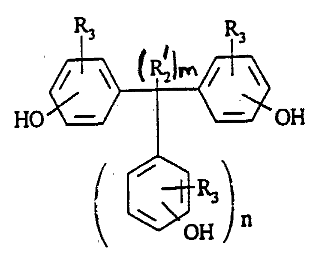 where n=0-2, m=0-2 provided m+n=2, R' is H or an alkyl C₁-C₂₀ and R₃ is the same as defined herein.

Thus, PHS can be mixtures of linear, branched, and/or grafted polymers using the monomers and/or polymers set forth herein.

It has unexpectedly been found that the use of a carboxylic acid with a carbinol to form a reaction mixture and the subsequent polymerization thereof results in a new PHS having a novolak type structure. The carboxylic acid employed not only acts as a reactant, but also as a solvent. The exact theory of what causes the formation of this PHS is not exactly known. However, it is theorized that the carboxylic acid acts (or functions) in a dual capacity, i.e. as a reactant and as a solvent. The present applicant does not, however, desire to be limited by any theory. As previously mentioned, the use of a carboxylic acid is a critical feature of this invention.

The carboxylic acid employed includes, without limitation, formic, acetic, propanoic, butyric, valeric, caproic, heptanoic, octanoic, nonanoic, undecanoic, isobutyric, isovaleric, cyclohexane carboxylic acid, and mixtures thereof. It is also critical that the particular carboxylic acid be a saturated carboxylic acid, i.e. a straight chain saturated carboxylic acid, a substituted saturated carboxylic acid, and/or ring carboxylic acid. The amount of carboxylic acid used is any amount which provides a molar reaction and also acts as a solvent. Thus, a more than equivalent molar amount of carboxylic acid with respect to the carbinol is used, and the excess of carboxylic acid may be up to twenty (and greater) times the carbinol moles.

The temperature, pressure, and time at which the carboxylic acid and carbinol are mixed together are not critical; however, it is desirable to employ the carboxylic acid in liquid form. Thus, the upper limit on temperature would desirably be the liquid/gas phase temperature of the carboxylic acid.

The catalyst employed in the present invention process is critical and is preferably selected from the group H₂SO₄, HCl, AlCl₃, H₃PO₄, oxalic acid, SnCl₂, BF₃, BBr₃, BCl₃, para-toluene sulfonic acid, and methane sulfonic acid. Thus, Lewis acids and protic acids having a pKa of less than 4.75 are suitable.

The catalyst is used in any amount in order to facilitate the reaction, i.e. polymerization, to yield the PH3 which has a novolak type structure. Such amounts generally are from about one part per million (ppm) to 100,000 ppm, or higher.

The temperature employed in the polymerization is generally less than 120°C, more specifically from 0°C to 120°C. The reaction pressure may be subatmospheric, atmospheric, or superatmospheric.

The length of time which this polymerizarion step is conducted is not critical and the only requirement is that the polymerization be conducted for a period of time sufficient to form PHS having a novolak type structure. Generally, this period is at least five minutes and may be as long as 25 hours.

After the polymerization of the reaction mixture (i.e. carboxylic acid + carbinol + any nucleating agent), the desired end product (PHS) is recovered from the reaction product and the residual fraction containing any unreacted carbinol can be recycled as part of the starting material for the next cycle. The end product (PHS) may be recovered from the reaction product by any method; for example, it can be separated from the fraction containing the unreacted carbinol by, e.g. precipitation in water followed by filtration, or any other suitable technique.

It is also within the scope of the present invention to utilize a nucleating agent like a seed monomer in order to prepare the reaction mixture. Such material does not have to be a carbinol falling within Formula I, nor does it have to contain any hydroxy groups. Such nucleating agents may include, without limitation, the substituted phenols and substituted triarylalkyls defined herein.

It is also within the scope of the present invention to employ a chain terminating agent after the polymerization step. Any type of chain terminating agent may be used as long as there is no substantial adverse effect on the novolak structure of the PHS formed.

It is also within the scope of the present invention to employ two or more carbinols in the reaction mixture or to use one or more carbinols in subsequent polymerizations after the initial polymerization; i.e. sequential polymerization with a different carbinol at each polymerization stage.

It is possible to utilize a non-novolak type polyhydroxystyrene homopolymer to add to the "carbinol/carboxylic acid" reaction mixture and then subject the overall reaction mixture to alkylation/polymerization to prepare a partial novolak type structure of polyhydroxystyrene.

In addition to the use of PHS (with a novolak-type structure) in the microelectronic chemicals market, such PHS can be employed in standard novolak applications such as varnishes, aniline printing inks, raw materials for epoxy resins, copying paper, tackifiers for rubber, and crude oil separators.

The following specific examples are supplied for the purpose of better illustrating the invention. These examples are not intended, however, to limit or restrict the scope of the invention in any way and should not be construed as providing conditions, parameters, or values which must be utilized exclusively in order to practice the present invention.

### EXAMPLES 1-11

The following procedure was used in all 11 examples to prepare PHS. This procedure illustrates Example 4.

A three-neck three-liter flask was fitted with a condenser, thermowell, nitrogen purge, and mechanical stirrer. To the flask was added 4-hydroxyphenylmethylcarbinol (HPMC) (352.0 g, 2.55 mol) and glacial acetic acid (1051.9 g, 17.52 mol). Not all of the HPMC was dissolved. The suspension was cooled to 9°C using an ice bath and sulfuric acid (1.0 g) was added. The ice bath was removed and the suspension was allowed to warm, and at 19°C, all of the HPMC dissolved. The mixture exothermed, reaching a maximum temperature of 35°C. The reaction was stirred overnight at room temperature. The solution was poured into water (3 x 3000 mL), and the solid was isolated by filtration. The solid was washed with water (3 x 1000 mL), vacuum dried (50°C, 8000 Pa (60 torr), 2 days), and weighed (288.7 g, 94.3%).

The solid obtained is a bright white powder which is soluble in acetone, methanol, tetrahydrofuran, and aqueous base and is insoluble in non-polar organics. The weight average molecular weight is 5600 and the number average molecular weight is 3675, giving a polydispersity of 1.53. The thermal stability by TGA showed no decomposition below 200°C and the glass transition temperature is 143°C. The experimental conditions and results are shown in Tables 1, 2, 3, and 4.

### EXAMPLE 12 (COMPARATIVE)

The procedure set forth in Examples 1-11 above were utilized except in Example 12, methanol was used instead of acetic acid. Example 12 yielded the benzyl ether (4-hydroxyphenylmethylcarbinol methyl ether) which did not form the PHS (with a novolak-like structure) upon polymerization. Thus, organic alcohols are not suitable replacements for carboxylic acids. in order to form a novolak type structure.

### DISCUSSION

In view of the experimental results, it would appear that the use of a carboxylic acid (e.g. acetic acid), with the carbinol, forms, e.g. an acetate, as determined by ¹H NMR and by TLC analysis of the reaction mixture prior to polymerization. The subsequent addition of the catalyst (e.g. H₂SO₄) promotes the formation of polyalkylated homopolymers of 4-HPMC. This overall reaction is shown in Scheme 1 as follows:

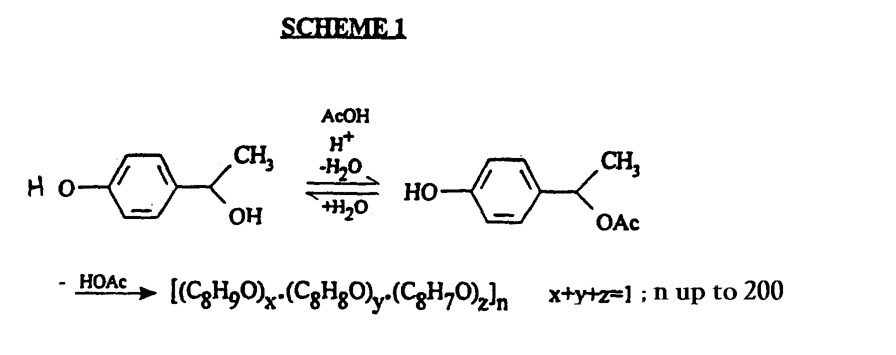

It was also found that 2-hydroxyphenylmethylcarbinol, 3-methyl-4-hydroxyphenylmethylcarbinol, 4-acetoxyphenylmethylcarbinol, 3-methyl-4-acetoxyphenylmethylcarbinol, and 4-hydroxybenzylalcohol all reacted under similar conditions to give polyalkylated polymers. In addition, it was found that poly(4-hydroxystyrene) was alkylated under these conditions with 4-HPMC, Table 1.

The polymerizations are shown in Tables 1,2,3, and 4. In all cases, the conversions were high, with no detectable remaining monomers as analyzed by TLC or GPC. The GPC analysis of these polymers are given in Table 2. The weight average molecular weight of a series of 4-HPMC polymers ranged from 5,300 to 7,000. Most of the polydispersities were lower than 2.00. Thermal analysis showed, for the 5,000 to 6,000 molecular weight polymers of 4-BPMC, a glass transition temperature of 143°C with no weight loss below 200°C. The alkylation products of Example 4, using 4-HPMC, are shown in Tables 3 and 4. A comparison of the chemical shifts seen in the ¹³C NMR as compared to the monomer and a series of model compounds, shows three expected structures of the para, ortho-para, and ortho-ortho-para substituted structures (Table 3). For Example 4, these structures are in an approximate ratio of 1:1:1; however, the x+y+z (Scheme 1) equals 1, but the individual structures are not limited to 1:1:1 (or 1/3-1/3-1/3), thus there is no limitation on the structural ratio.

It is to be understood that the remarks above contain some theory as to the formation of PHS with a novolak type structure; however, Applicant does not wish to be so limited.

In the following Examples, the Example using HBA (Example 11 ) is not according to the invention and is included for comparison only.

**Table 1**

| Conditions for the polymerization of substituted phenyl carbinols | | | | | | | |
|---|---|---|---|---|---|---|---|
| ***Example*** | ***Reactant*** | ***Catalyst*** | ***Temp. (°C)*** | ***Time (hrs.)*** | ***Yield (%)*** | ***Weight*** % ***Acid*** | ***Weight % Solids*** |
| 1 | 4-HPMC¹ | H₂SO₄ | 25 | 1 | 87 | 4.0 | 20 |
| 2 | 4-HPMC | H₂SO₄ | 25 | 1.5 | 85 | 4.0 | 20 |
| 3 | 4-HPMC | H₂SO₄ | 25 | 16 | 69 | 0.4 | 20 |
| 4 | 4-HPMC | H₂SO₄ | 25 | 16 | 95 | 0.3 | 25 |
| 5 | 4-HPMC | H₂SO₄ | 25 | 16 | 88 | 0.2 | 25 |
| 6 | 4-HPMC | AlCl₃ | 55 | 16 | 91 | 0.6 | 21 |
| 7 | 4-HPMC | HCl | 55 | 16 | 85 | 0.6 | 20 |
| 8 | MHPMC² | H₂SO₄ | 25 | 16 | 86 | 0.4 | 20 |
| 9 | APMC³ | H₂SO₄ | 60 | 1 | - | - | - |
| 10 | 2-HPMC⁴ | H₂SO₄ | 25 | 16 | 87 | 0.01 | 18 |
| 11 | HBA⁵ | H₂SO₄ | 25 | 16 | - | 1 | 24 |

| | | | | | | | |
|---|---|---|---|---|---|---|---|
| ¹4-HPMC is 4-hydroxyphenylmethyl carbinol. | | | | | | | |
| ²MHPMC is 3-methyl-4-hydroxyphenylmethyl carbinol. | | | | | | | |
| ³APMC is 4-acetoxyphenylmethyl carbinol. | | | | | | | |
| ⁴2-HPMC is 2-hydroxyphenylmethyl carbinol. | | | | | | | |
| ⁵HBA is 4-hydroxybenzyl alcohol. | | | | | | | |

**Table 2**

| Polymerization of substituted phenyl carbinols in acetic acid. | | | | | | |
|---|---|---|---|---|---|---|
| ***Example*** | ***Reactant*** | ***Catalyst*** | ***M***_{***w***} | ***M***_{***n***} | ***PD***^{***1***} | ***T***_{***g***} ***(°C)*** |
| 1 | 4-HPMC² | H₂SO₄ | 5,604 | 3,460 | 1.62 | |
| 2 | 4-HPMC | H₂SO₄ | 6,600 | 3,466 | 1.90 | |
| 3 | 4-HPMC | H₂SO₄ | 6,300 | 3,172 | 1.98 | 143 |
| 4 | 4-HPMC | H₂SO₄ | 5,600 | 3,675 | 1.53 | 143 |
| 5 | 4-HPMC | H₂SO₄ | 6,900 | 4,564 | 1.52 | |
| 6 | 4-HPMC | AlCl₃ | 1,835 | 1,407 | 1.30 | |
| 7 | 4-HPMC | HCl | 2,821 | 2,097 | 1.35 | |
| 8 | MHPMC³ | H₂SO₄ | 3,900 | 2,248 | 1.74 | |
| 9 | APMC⁴ | H₂SO₄ | 2,686 | 1,875 | 1.43 | |
| 10 | 2-HPMC⁵ | H₂SO₄ | 3,525 | 2,285 | 1.54 | |
| 11 | HBA⁶ | H₂SO₄ | 45,700 | 3,242 | 14.09 | |

| | | | | | | |
|---|---|---|---|---|---|---|
| ¹PD is polydispersity (M_{w}/Mₙ). | | | | | | |
| ²4-HPMC is 4-hydroxyphenylmethyl carbinol. | | | | | | |
| ³MHPMC is 3-methyl-4-hydroxyphenylmethyl carbinol. | | | | | | |
| ⁴APMC is 4-acetoxyphenylmethyl carbinol. | | | | | | |
| ⁵2-HPMC is 2-hydroxyphenylmethyl carbinol. | | | | | | |
| ⁶HBA is 4-hydroxybenzyl alcohol. | | | | | | |

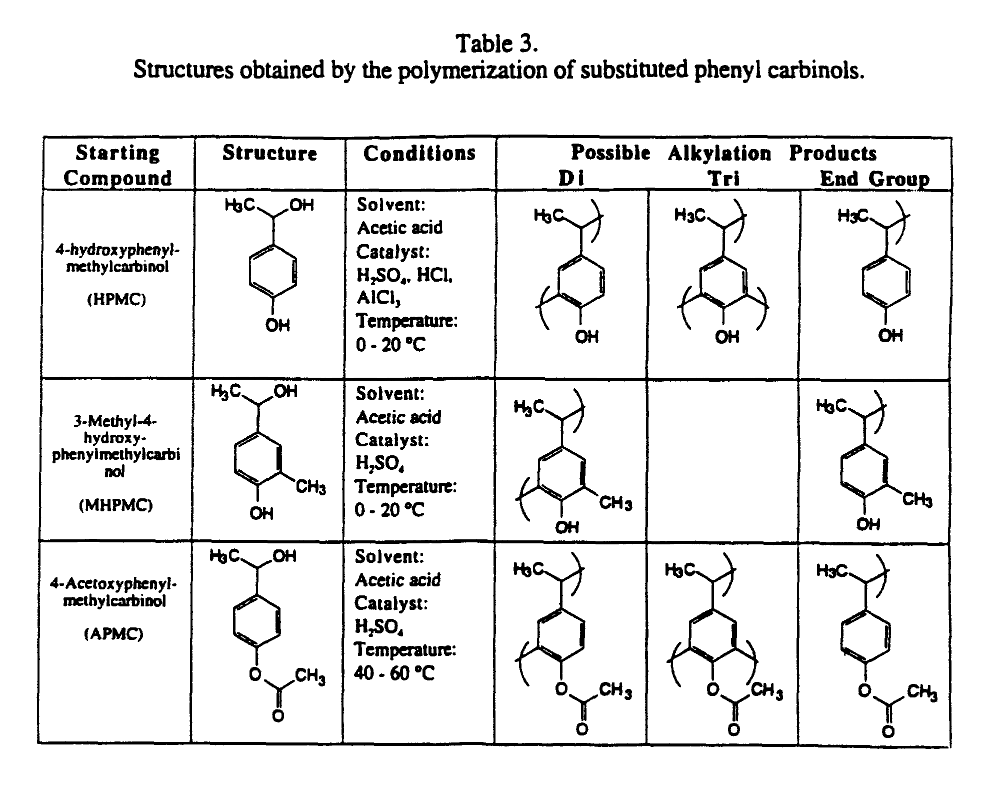

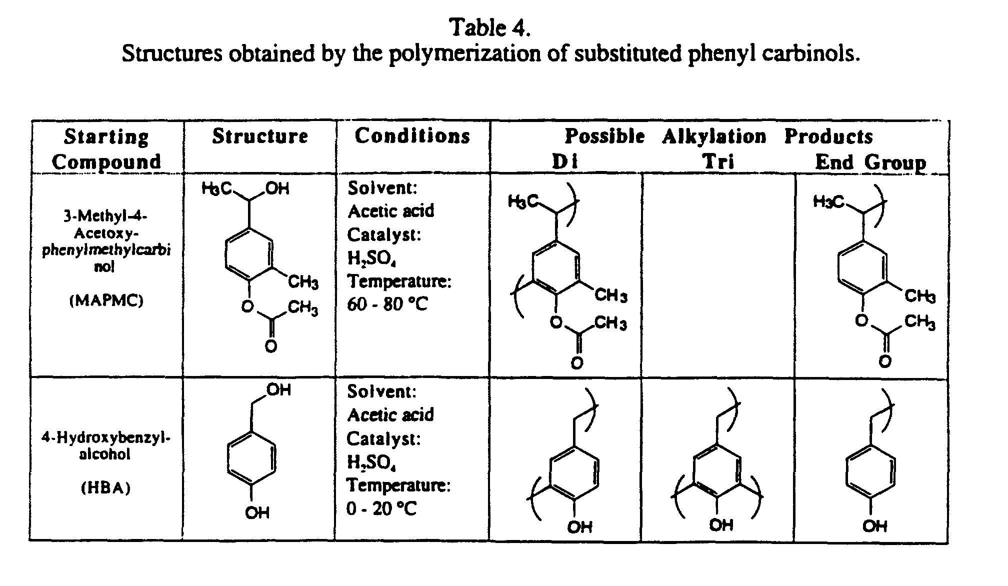

## Claims

1. A process for preparing polyhydroxystyrene having a novolak type structure which comprises the steps of (a) mixing at least one substituted phenyl carbinol with a saturated carboxylic acid which is present in an amount which is greater than the molar equivalent of the carbinol to form a reaction mixture, and (b) polymerizing said reaction mixture in the presence of a suitable catalyst to form a novolak type polymer.

2. The process as set forth in claim 1 wherein said carbinol has the formula: 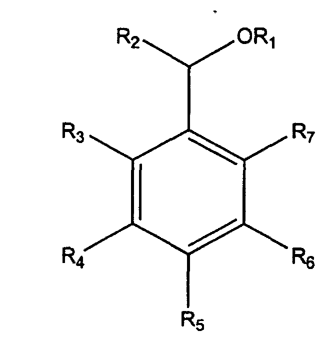 wherein R₁ is selected from the group consisting of H, alkyl C₁-C₂₀, substituted and unsubstituted phenyl, and C(O)R₈ (where R₈ is alkyl C₁-C₂₀); R₂ is selected from the group consisting of alkyl C₁-C₂₀; and R₃-R₇ are each independently selected from the group consisting of H; alkyl C₁-C₂₀, OR₉ (where R₉ is H, alkyl C₁-C₂₀, esters thereof, or substituted or unsubstituted phenyl), halogen, BZT, nitro and amino; with the proviso that at least one of R₃-R₇ is OR₉.

3. The process as set forth in claim 1 or 2 wherein said catalyst is a Lewis acid.

4. The process as set forth in any of claims 1-3 wherein the temperature in steps (a) and (b) is from 0°C to 120°C.

5. The process as set forth in claim 1 or 2 wherein said catalyst is selected from the group consisting of H₂SO₄, HCl, AlCl₃, H₃PO₄, oxalic acid, SnCl₂, BF₃, BBr₃, BCl₃, para-toluene sulfonic acid, and methane sulfonic acid.

6. The process as set forth in any of claims 1-5 wherein said carboxylic acid is acetic acid.

7. The process as set forth in any of claims 1-6 wherein said catalyst is H₂SO₄.

8. The process as set forth in any of claims 1-7 wherein said carbinol is selected from the group consisting of 4-hydroxyphenylmethylcarbinol, 2-hydroxyphenylmethylcarbinol, and mixtures thereof.

9. The process as set forth in any of claims 1-7 wherein said carbinol is 3-methyl-4-hydroxyphenylmethylcarbinol.

10. The process as set forth in any of claims 1-7 wherein said carbinol is 4-acetoxyphenylmethylcarbinol.

11. The process as set forth in any of claims 1-7 wherein said carbinol is 3-methyl-4-acetoxyphenylmethylcarbinol.

12. The process as set forth in any of claims 1-11 wherein there are at least two carbinols in said reaction mixture in step (a).

13. The process as set forth in claim 13 wherein there are at least two carbinols used and said second and any other carbinols are individually added after the previous polymerization step in order to form a novolak type block polymer.

14. The process as set forth in any of claims 1-13 wherein there is further included in step (a) a nucleating agent.

15. The process of any of claims 1-14 wherein in step (a), a polyhydroxystyrene having a non-novolak type structure is added to the reaction mixture.

## Patentansprüche

1. Verfahren zum Herstellen von Polyhydroxystyrol, das eine Struktur vom Novolak-Typ hat, mit den folgenden Schritten, nämlich (a) Mischen von zumindest einem substituierten Phenylcarbinol mit einer gesättigten Carbonsäure, die in einer Menge vorliegt, die größer ist als das Mol-Äquivalent des Carbinols, um eine Reaktionsmischung zu bilden, und (b) Polymerisieren dieser Reaktionsmischung in Anwesenheit eines geeigneten Katalysators, um ein Polymer vom Novolak-Typ zu bilden.

2. verfahren nach Anspruch 1, wobei das Carbinol folgende Formel aufweist: 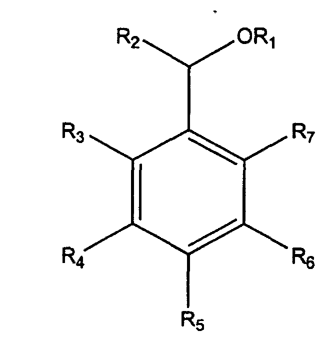 wobei R₁ ausgewählt ist aus der Gruppe bestehend aus H, C₁-C₂₀-Alkyl, substituiertem und unsubstituiertem Phenyl und C(O)R₈ (wobei R₈ ein C₁-C₂₀ Alkyl ist); R₂ ausgewählt ist aus der Gruppe bestehend aus C₁-C₂₀-Alkyl; und R₃-R₇, jeweils unabhängig voneinander, ausgewählt sind aus der Gruppe bestehend aus H, C₁-C₂₀-Alkyl, OR₉ (wobei R₉ ein H, ein C₁-C₂₀-Alkyl, ein Ester davon oder ein substituiertes oder unsubstituiertes Phenyl ist), Halogen, BZT, Nitro und Amino; mit der Bedingung, dass zumindest eines von R₃-R₇ OR₉ ist.

3. Verfahren nach Anspruch 1 oder 2, bei dem der Katalysator eine Lewissäure ist.

4. Verfahren nach einem der Ansprüche 1 bis 3, bei dem die Temperatur in Schritt (a) und (b) von 0°C bis 120°C liegt.

5. Verfahren nach einem der Ansprüche 1 oder 2, bei dem der Katalysator ausgewählt ist aus der Gruppe bestehend aus H₂SO₄, HCl, AlCl₃, H₃PO₄, Oxalsäure, SnCl₂, BF₃, BBr₃, BCl₃, para-Toluolsulfonsäure und Methansulfonsäure.

6. Verfahren nach einem der Ansprüche 1 bis 5, bei dem die Carbonsäure Essigsäure ist.

7. Verfahren nach einem der Ansprüche 1 bis 6, bei dem der Katalysator H₂SO₄ ist.

8. Verfahren nach einem der Ansprüche 1 bis 7, bei dem das Carbinol ausgewählt ist aus der Gruppe bestehend aus 4-Hydroxyphenylmethylcarbinol, 2-Hydroxyphenylmethylcarbinol und Mischungen davon.

9. Verfahren nach einem der Ansprüche 1 bis 7, bei dem das Carbinol 3-Methyl-4-Hydroxyphenylmethylcarbinol ist.

10. Verfahren nach einem der Ansprüche 1 bis 7, bei dem das Carbinol 4-Acetoxyphenylmethylcarbinol ist.

11. Verfahren nach einem der Ansprüche 1 bis 7, bei dem das Carbinol 3-Methyl-4-Acetoxyphenylmethylcarbinol ist.

12. Verfahren nach einem der Ansprüche 1 bis 11, bei dem zumindest zwei Carbinole in der Reaktionsmischung in Schritt (a) enthalten sind.

13. Verfahren nach Anspruch 12, bei dem zumindest zwei Carbinole verwendet werden und das zweite und alle anderen Carbinole jeweils einzeln nach dem vorhergehenden Polymerisationsschritt zugegeben werden, um ein Blockpolymer vom Novolak-Typ zu bilden.

14. Verfahren nach einem der Ansprüche 1 bis 13, bei dem ferner in Schritt (a) ein Nukleierungsmittel enthalten ist.

15. Verfahren nach einem der Ansprüche 1 bis 14, bei dem in Schritt (a) ein Polyhydroxystyrol der Reaktionsmischung zugegeben wird, das eine Struktur vom Nicht-Novolak-Typ hat.

## Revendications

1. Procédé de préparation d'un polyhydroxystyrène ayant une structure de type novolaque, qui comprend les étapes (a) de mélange d'au moins un phénylcarbinol substitué avec un acide carboxylique saturé qui est présent en une quantité supérieure à l'équivalent molaire du carbi-nol, pour former un mélange réactionnel, et (b) de poly-mérisation dudit mélange réactionnel en présence d'un catalyseur approprié, pour former un polymère de type novolaque.

2. Procédé selon la revendication 1, dans lequel ledit carbinol a la formule : 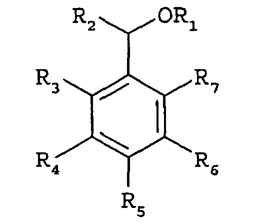 dans laquelle R₁ est choisi dans l'ensemble comprenant H, les groupes alkyle en C₁-C₂₀, phényle substitué et non-substitué, et C(O)R₈ (où R₈ est un groupe alkyle en C₁-C₂₀) ; R₂ est choisi dans l'ensemble comprenant les groupes alkyle en C₁-C₂₀ ; et R₃ à R₇ sont choisis chacun indépendamment des autres dans l'ensemble comprenant H, les groupes alkyle en C₁-C₂₀, OR₉ (où R₉ est H ou un groupe alkyle en C₁-C₂₀, leurs esters, ou un groupe phényle substitué ou non substitué), halogéno, BZT, nitro et amino ; à la condition qu'au moins l'un des radicaux R₃ à R₇ soit OR₉.

3. Procédé selon la revendication 1 ou 2, dans lequel ledit catalyseur est un acide de Lewis.

4. Procédé selon l'une quelconque des revendications 1 à 3, dans lequel la température dans les étapes (a) et (b) est de 0 à 120°C.

5. Procédé selon la revendication 1 ou 2, dans lequel ledit catalyseur est choisi dans l'ensemble consistant en H₂SO₄, HCl, AlCl₃, H₃PO₄, acide oxalique, SnCl₂, BF₃, BBr₃, BCl₃, l' acide paratoluènesulfonique et l'acide méthanesulfonique.

6. Procédé selon l'une quelconque des revendications 1 à 5, dans lequel ledit acide carboxylique est l'acide acétique.

7. Procédé selon l'une quelconque des revendications 1 à 6, dans lequel ledit catalyseur est H₂SO₄.

8. Procédé selon l'une quelconque des revendications 1 à 7, dans lequel ledit carbinol est choisi dans l'ensemble consistant en le 4-hydroxyphénylméthylcarbinol, le 2-hydroxyphénylméthylcarbinol et leurs mélanges.

9. Procédé selon l'une quelconque des revendications 1 à 7, dans lequel ledit carbinol est le 3-méthyl-4-hydroxyphénylméthylcarbinol.

10. Procédé selon l'une quelconque des revendications 1 à 7, dans lequel ledit carbinol est le 4-acétoxyphénylméthylcarbinol.

11. Procédé selon l'une quelconque des revendications 1 à 7, dans lequel ledit carbinol est le 3-méthyl-4-acétoxyphénylméthylcarbinol.

12. Procédé selon l'une quelconque des revendications 1 à 11, dans lequel ledit mélange réactionnel de l'étape (a) contient au moins deux carbinols.

13. Procédé selon la revendication 12, dans lequel il y a au moins deux carbinols utilisés, et ledit deuxième ou tous autres carbinols sont ajoutés d'une manière individuelle après l'étape précédente de polymérisation pour former un polymère à blocs de type novolaque.

14. Procédé selon l'une quelconque des revendications 1 à 13, dans lequel l'étape (a) comprend en outre un agent de nucléation.

15. Procédé selon l'une quelconque des revendications 1 à 14, dans lequel, dans l'étape (a), un polyhydroxystyrène ayant une structure autre qu'une structure de type novolaque est ajouté au mélange réactionnel.
